# EUROPEAN PATENT APPLICATION

(11) **EP 4 618 423 A1**
(43) Date of publication of application: **17.09.2025**
(21) Application number: 23920911.7
(22) Date of filing: 20.12.2023
(51) Int. Cl.: H03M 1/32, H03M 1/38

(54) **GAIN AMPLIFIER, AND PIPELINED SUCCESSIVE APPROXIMATION REGISTER ANALOG-TO-DIGITAL CONVERTER**

(30) Priority: 09.02.2023 CN 202310136717
(71) Applicant: Sanechips Technology Co., Ltd., Shenzhen, Guangdong 518055 (CN)
(72) Inventor: SHEN, Yiwan, Shenzhen, Guangdong 518055 (CN); SHEN, Xiongjie, Shenzhen, Guangdong 518055 (CN); YI, Shengtao, Shenzhen, Guangdong 518055 (CN); DING, Xuewei, Shenzhen, Guangdong 518055 (CN)
(74) Representative: Canzler & Bergmeier Patentanwälte Partnerschaft mbB
(86) International application number: PCT/CN2023/140225
(87) International publication number: WO 2024/164722

(57) **Abstract**

Provided in the present application are a gain amplifier and a pipelined successive approximation register analog-to-digital converter. The gain amplifier comprises a passive gain network and a buffer. The passive gain network comprises at least one capacitor sampling array; each capacitor sampling array comprises n capacitors and (3n-2) switches, n being an integer greater than or equal to 1. The passive gain network is configured to, when the (3n-2) switches control the n capacitors to be connected in parallel, sample an input signal to obtain a sampled signal; and to, when the (3n-2) switches control the n capacitors to be connected in series, amplify the sampled signal to obtain an amplified signal. The buffer is configured to store and output the amplified signal.

## Description

### CROSS REFERENCE TO RELATED APPLICATIONS

The present disclosure claims the priority to Chinese Patent Application No. 202310136717.8 filed with the CNIPA on February 9, 2023, the contents of which are incorporated herein by reference in their entirety.

### TECHNICAL FIELD

The present disclosure relates to, but is not limited to, the technical field of electronic circuits.

### BACKGROUND

Nowadays, with the rapid development of cloud computing, machine learning, and artificial intelligence, the bandwidth of a data center is bound to increase, and the aim of doubling the bandwidth basically needs to be achieved in 3-4 years. In order to support newer and faster data interfaces, a receiving speed of a SERializer/DESerializer (SERDES) transceiver needs to be greatly improved, which makes a receiver based on a Time-Interleaved Analog-to-Digital Converter (TI-ADC) become a mainstream of design. The performance of the ADC is one of the key factors affecting the performance of the receiver. The speed of the TI-ADC is mainly determined by an interleaved-channel speed and a single-channel speed. Considering the area and power consumption cost caused by increasing the number of channels, a single-channel architecture of a Pipelined Successive Approximation Register (P-SAR) ADC is generally adopted to achieve the aim of improving the speed.

In an implementation process of the P-SAR ADC, an interstage gain amplifier is usually one of the design difficulties, and a gain of the interstage gain amplifier is changed under the effect of an operating environment and uncontrollable factors during processing, resulting in a mismatch between an actual gain and a designed gain. The change of the gain and the gain mismatch between channels may cause degradation of the performance of the TI-ADC. The existing methods for ensuring the stable performance of the amplifier need an additional detection circuit and an additional calibration circuit, which causes the problems of high cost, large area, high power consumption, and high implementation complexity.

### SUMMARY

The embodiments of the present disclosure provide a gain amplifier and a pipelined successive approximation register analog-to-digital converter.

In a first aspect, an embodiment of the present disclosure provides a gain amplifier, including: a passive gain network and a buffer; wherein the passive gain network includes at least one capacitor sampling array; each of the at least one capacitor sampling array includes: n capacitors and (3n-2) switches; wherein n is an integer greater than or equal to 1; wherein the passive gain network is configured to sample an input signal to obtain a sampled signal in a case where the n capacitors are connected in parallel under the control of the (3n-2) switches, and amplify the sampled signal to obtain an amplified signal in a case where the n capacitors are connected in series under the control of the (3n-2) switches; wherein the buffer is configured to store and output the amplified signal.

In a second aspect, an embodiment of the present disclosure provides a pipelined successive approximation register analog-to-digital converter, including: a first-stage pipelined successive approximation register analog-to-digital converter, which is configured to quantize an input voltage signal to obtain a first residual voltage signal and a first quantized voltage signal; an interstage gain amplifier, which is configured to amplify the first residual voltage signal to obtain an amplified first residual voltage signal; a second-stage pipelined successive approximation register analog-to-digital converter, which is configured to quantize the amplified first residual voltage signal to obtain a second quantized voltage signal; and an adder, which is configured to add the first quantized voltage signal to the second quantized voltage signal to obtain a final output signal; wherein the interstage gain amplifier includes: a passive gain network and a buffer; wherein the passive gain network includes at least one capacitor sampling array; each of the at least one capacitor sampling array includes: n capacitors and (3n-2) switches; wherein n is an integer greater than or equal to 1; wherein the passive gain network is configured to sample the first residual voltage signal to obtain a first sampled voltage signal in a case where the n capacitors are connected in parallel under the control of the (3n-2) switches, and amplify the first sampled voltage signal to obtain the amplified first residual voltage signal in a case where the n capacitors are connected in series under the control of the (3n-2) switches; wherein the buffer is configured to store and output the amplified first residual voltage signal.

### BRIEF DESCRIPTION OF DRAWINGS

FIG. 1 is a block diagram of a gain amplifier according to an embodiment of the present disclosure;
FIG. 2 is a schematic circuit diagram of a gain amplifier in a case where a passive gain network includes one capacitor sampling array;
FIG. 3 is a schematic circuit diagram of a gain amplifier in a case where a passive gain network includes two capacitor sampling arrays;
FIG. 4 is a schematic circuit diagram of a gain amplifier in a case where a passive gain network includes one capacitor sampling array and n is equal to 2 according to an embodiment of the present disclosure;
FIG. 5 is a schematic circuit diagram of a gain amplifier in a case where a passive gain network includes two capacitor sampling arrays and n is equal to 2 according to an embodiment of the present disclosure;
FIG. 6 is a schematic circuit diagram of a gain amplifier in a case where a passive gain network includes one capacitor sampling array and n is equal to 4 according to an embodiment of the present disclosure;
FIG. 7 is a schematic circuit diagram of a gain amplifier in a case where a passive gain network includes two capacitor sampling arrays and n is equal to 4 according to an embodiment of the present disclosure;
FIG. 8 is a schematic circuit diagram of a gain amplifier in a case where a passive gain network includes one capacitor sampling array and n is equal to 8 according to an embodiment of the present disclosure;
FIG. 9 is a schematic circuit diagram of a gain amplifier in a case where a passive gain network includes two capacitor sampling arrays and n is equal to 8 according to an embodiment of the present disclosure;
FIG. 10 is a block diagram of a P-SAR ADC according to another embodiment of the present disclosure;
FIG. 11 is a schematic circuit diagram of a P-SAR ADC according to an embodiment of the present disclosure; and
FIG. 12 is a block diagram of a time-interleaved P-SAR ADC according to another embodiment of the present disclosure.

### DETAIL DESCRIPTION OF EMBODIMENTS

In order to enable those of ordinary skill in the art to better understand the technical solutions of the present disclosure, a gain amplifier and a P-SAR ADC provided in the present disclosure are described in detail below with reference to the drawings.

Exemplary embodiments will be described more fully below with reference to the drawings, but the exemplary embodiments described herein may be embodied in different forms and should not be interpreted as being limited to the embodiments described herein. Rather, the embodiments are provided to make the present disclosure thorough and complete, and may enable those of ordinary skill in the art to fully understand the scope of the present disclosure.

The embodiments described herein and the features therein can be combined with one another if no conflict is incurred.

The term "and/or" used herein includes any and all combinations of at least one associated listed item.

The terms used herein are merely used to describe specific embodiments, and are not intended to limit the present disclosure. As used herein, "a" and "the" which indicate a singular form are intended to include a plural form, unless expressly stated in the context. It should be further understood that the term "include" and/or the term "be made of" used herein indicates the presence of the described features, integers, operations, elements and/or components, but do not exclude the presence or addition of at least one other feature, integer, operation, element, component and/or combinations thereof.

Unless otherwise defined, all terms (including technical terms and scientific terms) used herein have the same meaning as commonly understood by those of ordinary skill in the art. It should be further understood that terms, such as those defined in commonly used dictionaries, should be interpreted as having a meaning that is consistent with a meaning in the context of the related technology and the background of the present disclosure, and should not be interpreted in an idealized or overly formal sense unless expressly so defined herein.

Although the gain amplifier provided in the embodiments of the present disclosure is proposed based on the problem of the interstage gain amplifier in the P-SAR ADC, the gain amplifier provided in the embodiments of the present disclosure is not only applicable to the interstage gain amplifier in the P-SAR ADC, but also applicable to circuits in other application scenarios, e.g., a circuit satisfying the law of conservation of charge.

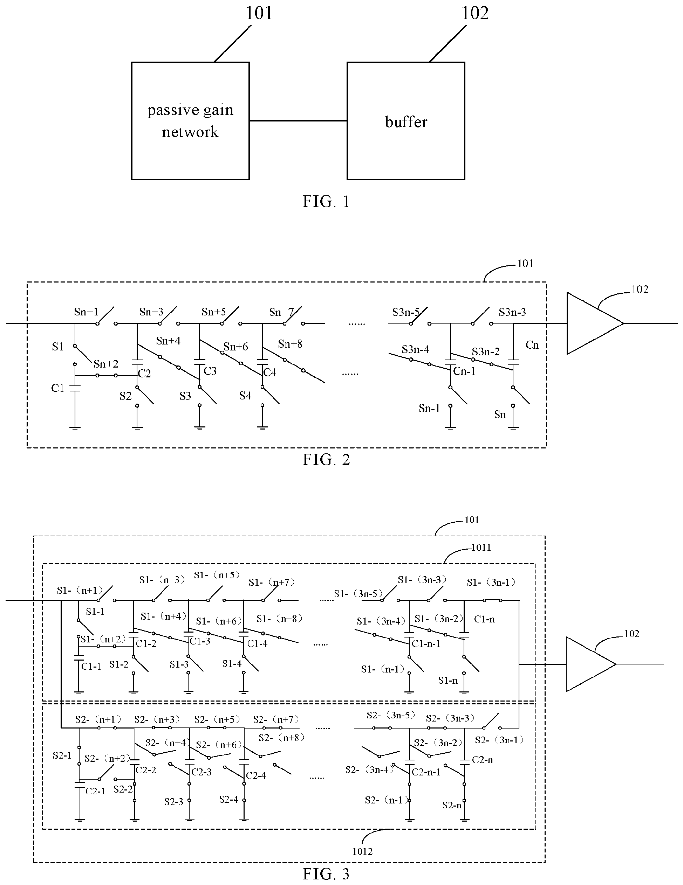

FIG. 1 is a block diagram of a gain amplifier according to an embodiment of the present disclosure.

In a first aspect, referring to FIG. 1, an embodiment of the present disclosure provides a gain amplifier, including: a passive gain network 101 and a buffer 102.

The passive gain network 101 includes at least one capacitor sampling array; and each capacitor sampling array includes: n capacitors and (3n-2) switches, with n being an integer greater than or equal to 1.

The passive gain network 101 is configured to sample an input signal to obtain a sampled signal in a case where the n capacitors are connected in parallel under the control of the (3n-2) switches, and amplify the sampled signal to obtain an amplified signal in a case where the n capacitors are connected in series under the control of the (3n-2) switches.

The buffer 102 is configured to store and output the amplified signal.

In the embodiment of the present disclosure, when the passive gain network 101 samples the input signal, the n capacitors are in a charging state, and a value of charges stored by each of the n capacitors is C×Vres, with C denoting a capacitance value and Vres denoting the input signal; and when the passive gain network 101 amplifies the sampled signal, the n capacitors are in a discharging state, and if the capacitance values of the n capacitors are equal to each other, a total capacitance value of the n capacitors connected in series is 1/n of the capacitance value of each capacitor connected in parallel, and an output signal is n×Vres, which achieves an n-times gain.

In some exemplary embodiments, the passive gain network 101 may include one capacitor sampling array or two capacitor sampling arrays. In a case where the passive gain network 101 includes two capacitor sampling arrays, as shown in FIG. 3, the two capacitor sampling arrays included in the passive gain network 101 are the first capacitor sampling array 1011 and a second capacitor sampling array 1012, respectively.

FIG. 2 is a schematic circuit diagram of a gain amplifier in a case where the passive gain network 101 includes one capacitor sampling array. As shown in FIG. 2, in a case where the passive gain network 101 includes one capacitor sampling array, the capacitor sampling array includes: n capacitors and (3n-2) switches. The n capacitors are a capacitor C1, a capacitor C2, a capacitor C3 ... and a capacitor Cn respectively, and the (3n-2) switches are a switch S1, a switch S2, a switch S3 ... and a switch S3n-2 respectively.

In some exemplary embodiments, in a case where the passive gain network 101 includes the one capacitor sampling array, a connection relationship among the n capacitors and the (3n-2) switches in the capacitor sampling array is as follows: as shown in FIG. 2, one end of the first switch S1 is connected to an input end of the passive gain network and one end of the (n+1)^{th} switch Sn+1, the other end of the first switch S1 is connected to a top plate of the first capacitor C1 and one end of the (n+2)^{th} switch Sn+2, and a bottom plate of the first capacitor C1 is grounded. In the present disclosure, for the sake of distinction, "one end" of a switch may refer to an upstream end of the switch, e.g., left ends of the horizontal switches in FIG. 2 or upper ends of the vertical or oblique switches in FIG. 2, and "the other end" of the switch may refer to the other one of the two ends of the switch except for the one end.

In a case where i is greater than or equal to 2 and less than n, a top plate of the i^{th} capacitor Ci is connected to the other end of the (n+2i-3)^{th} switch Sn+2i-3, one end of the (n+2i-1)^{th} switch Sn+2i-1, and one end of the (n+2i)^{th} switch Sn+2i, a bottom plate of the i^{th} capacitor Ci is connected to the other end of the (n+2i-2)^{th} switch Sn+2i-2 and one end of the i^{th} switch Si, and the other end of the i^{th} switch Si is grounded.

A top plate of the n^{th} capacitor Cn is connected to the other end of the (3n-3)^{th} switch S3n-3 and an output end of the passive gain network, a bottom plate of the n^{th} capacitor Cn is connected to the other end of the (3n-2)^{th} switch S3n-2 and one end of the n^{th} switch Sn, and the other end of the n^{th} switch Sn is grounded.

As shown in FIG. 2, when the first switch S1 to the n^{th} switch Sn, the (n+1)^{th} switch Sn+1, the (n+3)^{th} switch Sn+3, the (n+5)^{th} switch Sn+5, the (n+7)^{th} switch Sn+7 ... the (3n-5)^{th} switch S3n-5, and the (3n-3)^{th} switch S3n-3 are in an off state, and the (n+2)^{th} switch Sn+2, the (n+4)^{th} switch Sn+4, the (n+6)^{th} switch Sn+6, the (n+8)^{th} switch Sn+8 ... the (3n-4)^{th} switch S3n-4, and the (3n-2)^{th} switch S3n-2 are in an on state, the capacitors C1-Cn are connected in series.

When the first switch S1 to the n^{th} switch Sn, the (n+1)^{th} switch Sn+1, the (n+3)^{th} switch Sn+3, the (n+5)^{th} switch Sn+5, the (n+7)^{th} switch Sn+7 ... the (3n-5)^{th} switch S3n-5, and the (3n-3)^{th} switch S3n-3 are in an on state, and the (n+2)^{th} switch Sn+2, the (n+4)^{th} switch Sn+4, the (n+6)^{th} switch Sn+6, the (n+8)^{th} switch Sn+8 ... the (3n-4)^{th} switch S3n-4, and the (3n-2)^{th} switch S3n-2 are in an off state, the capacitors C1-Cn are connected in parallel.

FIG. 3 is a schematic circuit diagram of a gain amplifier in a case where the passive gain network 101 includes two capacitor sampling arrays. As shown in FIG. 3, in a case where the passive gain network 101 includes two capacitor sampling arrays, each capacitor sampling array includes: n capacitors and (3n-1) switches. The n capacitors in a first capacitor sampling array are a capacitor C1-1, a capacitor C1-2, a capacitor C1-3 ... and a capacitor C1-n respectively, and the (3n-1) switches in the first capacitor sampling array are a switch S1-1, a switch S1-2, a switch S1-3 ... and a switch S1-(3n-1) respectively; and the n capacitors in a second capacitor sampling array are a capacitor C2-1, a capacitor C2-2, a capacitor C2-3 ... and a capacitor C2-n respectively, and the (3n-1) switches in the second capacitor sampling array are a switch S2-1, a switch S2-2, a switch S2-3 ... and a switch S2-(3n-1) respectively.

In some exemplary embodiments, as shown in FIG. 3, in a case where the passive gain network 101 includes the first capacitor sampling array 1011 and the second capacitor sampling array 1012, the first capacitor sampling array 1011 is configured to, in a (2j-1)^{th} period, sample the input signal to obtain the sampled signal in a case where the n capacitors are connected in parallel under the control of the (3n-2) switches, and amplify the sampled signal to obtain the amplified signal in a case where the n capacitors are connected in series under the control of the (3n-2) switches; and hold the amplified signal in a 2j^{th} period, with j being an integer greater than or equal to 1.

The second capacitor sampling array 1012 is configured to, in the 2j^{th} period, sample the input signal to obtain the sampled signal in a case where the n capacitors are connected in parallel under the control of the (3n-2) switches, and amplify the sampled signal to obtain the amplified signal in a case where the n capacitors are connected in series under the control of the (3n-2) switches; and hold the amplified signal in a (2j+1)^{th} period.

The buffer is configured to store and output the amplified signal from the first capacitor sampling array in the (2j-1)^{th} period, and store and output the amplified signal from the second capacitor sampling array in the 2j^{th} period.

That is, in a case where the passive gain network 101 includes the two capacitor sampling arrays, the two capacitor sampling arrays perform a gain amplification function by adopting a ping-pong operating mode.

In some exemplary embodiments, in the (2j-1)^{th} period, the (3n-1)^{th} switch S1-(3n-1) in the first capacitor sampling array is in an on state, and the (3n-1)^{th} switch S2-(3n-1) in the second capacitor sampling array is in an off state.

In the 2j^{th} period, the (3n-1)^{th} switch S2-(3n-1) in the second capacitor sampling array is in an on state, and the (3n-1)^{th} switch S1-(3n-1) in the first capacitor sampling array is in an off state.

In some exemplary embodiments, in a case where the passive gain network 101 includes the two capacitor sampling arrays, a connection relationship among the n capacitors and the (3n-1) switches in the first capacitor sampling array is as follows: as shown in FIG. 3, one end of the first switch S1-1 is connected to the input end of the passive gain network and one end of the (n+1)^{th} switch S1-(n+1), the other end of the first switch S1-1 is connected to a top plate of the first capacitor C1-1 and one end of the (n+2)^{th} switch S1-(n+2), and a bottom plate of the first capacitor C1-1 is grounded.

In a case where i is greater than or equal to 2 and less than n, a top plate of the i^{th} capacitor C1-i is connected to the other end of the (n+2i-3)^{th} switch S1-(n+2i-3), one end of the (n+2i-1)^{th} switch S1-(n+2i-1), and one end of the (n+2i)^{th} switch S1-(n+2i), a bottom plate of the i^{th} capacitor C1-i is connected to the other end of the (n+2i-2)^{th} switch S1-(n+2i-2) and one end of the i^{th} switch S1-i, and the other end of the i^{th} switch S1-i is grounded.

A top plate of the n^{th} capacitor C1-n is connected to the other end of the (3n-3)^{th} switch S1-(3n-3) and one end of the (3n-1)^{th} switch S1-(3n-1), a bottom plate of the n^{th} capacitor C1-n is connected to the other end of the (3n-2)^{th} switch S1-(3n-2) and one end of the n^{th} switch S1-n, and the other end of the n^{th} switch S1-n is grounded.

The other end of the (3n-1)^{th} switch S1-(3n-1) is connected to the output end of the passive gain network.

As shown in FIG. 3, when the first switch S1-1 to the n^{th} switch S1-n, the (n+1)^{th} switch S1-(n+1), the (n+3)^{th} switch S1-(n+3), the (n+5)^{th} switch S1-(n+5), the (n+7)^{th} switch S1-(n+7) ... the (3n-5)^{th} switch S1-(3n-5), and the (3n-3)^{th} switch S1-(3n-3) in the first capacitor sampling array are in an off state, and the (n+2)^{th} switch S1-(n+2), the (n+4)^{th} switch S1-(n+4), the (n+6)^{th} switch S1-(n+6), the (n+8)^{th} switch S1-(n+8) ... the (3n-4)^{th} switch S1-(3n-4), and the (3n-2)^{th} switch S1-(3n-2) in the first capacitor sampling array are in an on state, the capacitors C1-1-C1-n are connected in series.

When the first switch S1-1 to the n^{th} switch S1-n, the (n+1)^{th} switch S1-(n+1), the (n+3)^{th} switch S1-(n+3), the (n+5)^{th} switch S1-(n+5), the (n+7)^{th} switch S1-(n+7) ... the (3n-5)^{th} switch S1-(3n-5), and the (3n-3)^{th} switch S1-(3n-3) in the first capacitor sampling array are in an on state, and the (n+2)^{th} switch S1-(n+2), the (n+4)^{th} switch S1-(n+4), the (n+6)^{th} switch S1-(n+6), the (n+8)^{th} switch S1-(n+8) ... the (3n-4)^{th} switch S1-(3n-4), and the (3n-2)^{th} switch S1-(3n-2) in the first capacitor sampling array are in an off state, the capacitors C1-1-C1-n are connected in parallel.

A connection relationship among the n capacitors and the (3n-1) switches in the second capacitor sampling array is as follows:
as shown in FIG. 3, one end of the first switch S2-1 is connected to the input end of the passive gain network and one end of the (n+1)^{th} switch S2-(n+1), the other end of the first switch S2-1 is connected to a top plate of the first capacitor C2-1 and one end of the (n+2)^{th} switch S2-(n+2), and a bottom plate of the first capacitor C2-1 is grounded.

In a case where i is greater than or equal to 2 and less than n, a top plate of the i^{th} capacitor C2-i is connected to the other end of the (n+2i-3)^{th} switch S2-(n+2i-3), one end of the (n+2i-1)^{th} switch S2-(n+2i-1), and one end of the (n+2i)^{th} switch S2-(n+2i), a bottom plate of the i^{th} capacitor C1-i is connected to the other end of the (n+2i-2)^{th} switch S2-(n+2i-2) and one end of the i^{th} switch S2-i, and the other end of the i^{th} switch S2-i is grounded.

A top plate of the n^{th} capacitor C2-n is connected to the other end of the (3n-3)^{th} switch S2-(3n-3) and one end of the (3n-1)^{th} switch S2-(3n-1), a bottom plate of the n^{th} capacitor C2-n is connected to the other end of the (3n-2)^{th} switch S2-(3n-2) and one end of the n^{th} switch S2-n, and the other end of the n^{th} switch S2-n is grounded.

The other end of the (3n-1)^{th} switch S2-(3n-1) is connected to the output end of the passive gain network.

As shown in FIG. 3, when the first switch S2-1 to the n^{th} switch S2-n, the (n+1)^{th} switch S2-(n+1), the (n+3)^{th} switch S2-(n+3), the (n+5)^{th} switch S2-(n+5), the (n+7)^{th} switch S2-(n+7) ... the (3n-5)^{th} switch S2-(3n-5), and the (3n-3)^{th} switch S2-(3n-3) in the second capacitor sampling array are in an off state, and the (n+2)^{th} switch S2-(n+2), the (n+4)^{th} switch S2-(n+4), the (n+6)^{th} switch S2-(n+6), the (n+8)^{th} switch S2-(n+8) ... the (3n-4)^{th} switch S2-(3n-4), and the (3n-2)^{th} switch S2-(3n-2) in the second capacitor sampling array are in an on state, the capacitors C2-1-C2-n are connected in series.

When the first switch S2-1 to the n^{th} switch S2-n, the (n+1)^{th} switch S2-(n+1), the (n+3)^{th} switch S2-(n+3), the (n+5)^{th} switch S2-(n+5), the (n+7)^{th} switch S2-(n+7) ... the (3n-5)^{th} switch S2-(3n-5), and the (3n-3)^{th} switch S2-(3n-3) in the second capacitor sampling array are in an on state, and the (n+2)^{th} switch S2-(n+2), the (n+4)^{th} switch S2-(n+4), the (n+6)^{th} switch S2-(n+6), the (n+8)^{th} switch S2-(n+8) ... the (3n-4)^{th} switch S2-(3n-4), and the (3n-2)^{th} switch S2-(3n-2) in the second capacitor sampling array are in an off state, the capacitors C2-1-C2-n are connected in parallel.

In some exemplary embodiments, n is equal to 2^{m}, and m is an integer greater than or equal to 1.

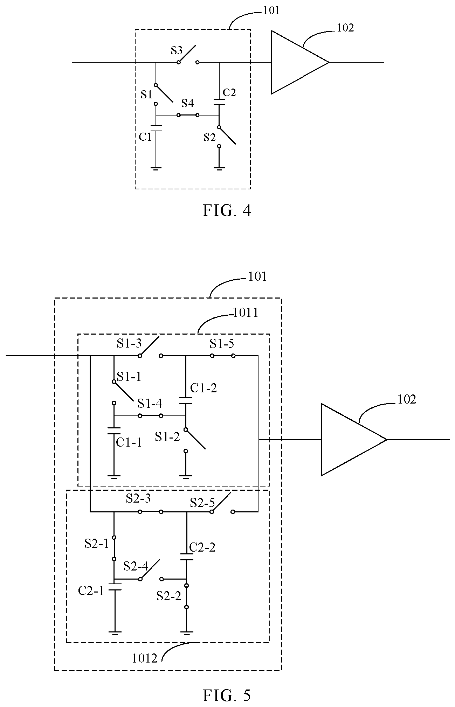

FIG. 4 is a schematic circuit diagram of a gain amplifier in a case where the passive gain network 101 includes one capacitor sampling array and n is equal to 2. As shown in FIG. 4, in a case where the passive gain network 101 includes one capacitor sampling array and n is equal to 2, the capacitor sampling array includes: two capacitors and four switches. The two capacitors are a capacitor C1 and a capacitor C2 respectively, and the four switches are a switch S1, a switch S2, a switch S3, and a switch S4 respectively.

In some exemplary embodiments, in a case where the passive gain network 101 includes the one capacitor sampling array and n is equal to 2, a connection relationship among the two capacitors and the four switches in the capacitor sampling array is as follows:
as shown in FIG. 4, one end of the first switch S1 is connected to the input end of the passive gain network and one end of the third switch S3, the other end of the first switch S1 is connected to a top plate of the first capacitor C1 and one end of the fourth switch S4, and a bottom plate of the first capacitor C1 is grounded.

A top plate of the second capacitor C2 is connected to the other end of the third switch S3 and the output end of the passive gain network, a bottom plate of the second capacitor C2 is connected to the other end of the fourth switch S4 and one end of the second switch S2, and the other end of the second switch S2 is grounded.

As shown in FIG. 4, when the first switch S1, the second switch S2, and the third switch S3 are in an off state and the fourth switch S4 is in an on state, the capacitor C1 and the capacitor C2 are connected in series.

When the first switch S1, the second switch S2, and the third switch S3 are in an on state and the fourth switch S4 is in an off state, the capacitor C1 and the capacitor C2 are connected in parallel.

FIG. 5 is a schematic circuit diagram of a gain amplifier in a case where the passive gain network 101 includes two capacitor sampling arrays and n is equal to 2. As shown in FIG. 5, in a case where the passive gain network 101 includes two capacitor sampling arrays and n is equal to 2, each capacitor sampling array includes: two capacitors and five switches. The two capacitors in a first capacitor sampling array are a capacitor C1-1 and a capacitor C1-2 respectively, and the five switches in the first capacitor sampling array are a switch S1-1, a switch S1-2, a switch S1-3 ... and a switch S1-5 respectively; and the two capacitors in a second capacitor sampling array are a capacitor C2-1 and a capacitor C2-2 respectively, and the five switches in the second capacitor sampling array are a switch S2-1, a switch S2-2, a switch S2-3 ... and a switch S2-5 respectively.

In some exemplary embodiments, in a case where the passive gain network 101 includes the two capacitor sampling arrays and n is equal to 2, a connection relationship among the two capacitors and the five switches in the first capacitor sampling array is as follows:
as shown in FIG. 5, one end of the first switch S1-1 is connected to the input end of the passive gain network and one end of the third switch S1-3, the other end of the first switch S1-1 is connected to a top plate of the first capacitor C1-1 and one end of the fourth switch S1-4, and a bottom plate of the first capacitor C1-1 is grounded.

A top plate of the second capacitor C1-2 is connected to the other end of the third switch S1-3 and one end of the fifth switch S1-5, a bottom plate of the second capacitor C1-2 is connected to the other end of the fourth switch S1-4 and one end of the second switch S1-2, and the other end of the second switch S1-2 is grounded.

The other end of the fifth switch S1-5 is connected to the output end of the passive gain network.

As shown in FIG. 5, when the first switch S1-1, the second switch S1-2, and the third switch S1-3 in the first capacitor sampling array are in an off state and the fourth switch S1-4 in the first capacitor sampling array is in an on state, the capacitor C1-1 and the capacitor C1-2 are connected in series.

When the first switch S1-1, the second switch S1-2, and the third switch S1-3 in the first capacitor sampling array are in an on state and the fourth switch S1-4 in the first capacitor sampling array is in an off state, the capacitor C1-1 and the capacitor C1-2 are connected in parallel.

In some exemplary embodiments, in a case where the passive gain network 101 includes the two capacitor sampling arrays and n is equal to 2, a connection relationship among the two capacitors and the five switches in the second capacitor sampling array is as follows:
as shown in FIG. 5, one end of the first switch S2-1 is connected to the input end of the passive gain network and one end of the third switch S2-3, the other end of the first switch S2-1 is connected to a top plate of the first capacitor C2-1 and one end of the fourth switch S2-4, and a bottom plate of the first capacitor C2-1 is grounded.

A top plate of the second capacitor C2-2 is connected to the other end of the third switch S2-3 and one end of the fifth switch S2-5, a bottom plate of the second capacitor C2-2 is connected to the other end of the fourth switch S2-4 and one end of the second switch S2-2, and the other end of the second switch S2-2 is grounded.

The other end of the fifth switch S2-5 is connected to the output end of the passive gain network.

As shown in FIG. 5, in a case where the first switch S2-1, the second switch S2-2, and the third switch S2-3 in the second capacitor sampling array are in an off state and the fourth switch S2-4 in the second capacitor sampling array is in an on state, the capacitor C2-1 and the capacitor C2-2 are connected in series.

When the first switch S2-1, the second switch S2-2, and the third switch S2-3 in the second capacitor sampling array are in an on state and the fourth switch S2-4 in the second capacitor sampling array is in an off state, the capacitor C2-1 and the capacitor C2-2 are connected in parallel.

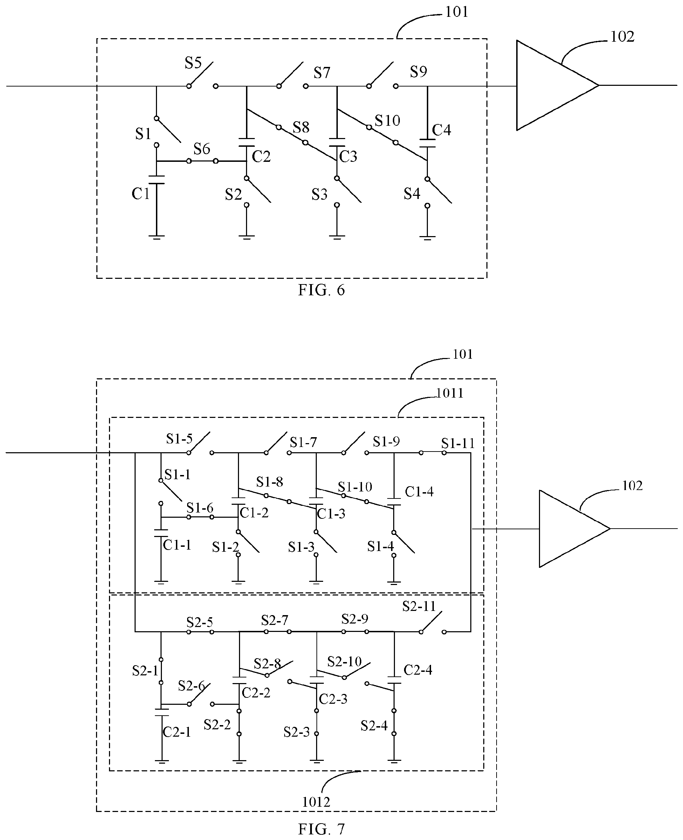

FIG. 6 is a schematic circuit diagram of a gain amplifier in a case where the passive gain network 101 includes one capacitor sampling array and n is equal to 4. As shown in FIG. 6, in a case where the passive gain network 101 includes one capacitor sampling array and n is equal to 4, the capacitor sampling array includes: four capacitors and ten switches. The four capacitors are a capacitor C1, a capacitor C2, a capacitor C3, and a capacitor C4 respectively, and the ten switches are a switch S1, a switch S2, a switch S3 ... and a switch S10 respectively.

In some exemplary embodiments, in a case where the passive gain network 101 includes the one capacitor sampling array and n is equal to 4, a connection relationship among the four capacitors and the ten switches in the capacitor sampling array is as follows:
as shown in FIG. 6, one end of the first switch S1 is connected to the input end of the passive gain network and one end of the fifth switch S5, the other end of the first switch S1 is connected to a top plate of the first capacitor C1 and one end of the sixth switch S6, and a bottom plate of the first capacitor C1 is grounded.

A top plate of the second capacitor C2 is connected to the other end of the fifth switch S5, one end of the seventh switch S7, and one end of the eighth switch S8, a bottom plate of the second capacitor C2 is connected to the other end of the sixth switch S6 and one end of the second switch S2, and the other end of the second switch S2 is grounded.

A top plate of the third capacitor C3 is connected to the other end of the seventh switch S7, one end of the ninth switch S9, and one end of the tenth switch S10, a bottom plate of the third capacitor C3 is connected to the other end of the eighth switch S8 and one end of the third switch S3, and the other end of the third switch S3 is grounded.

A top plate of the fourth capacitor C4 is connected to the other end of the ninth switch S9 and the output end of the passive gain network, a bottom plate of the fourth capacitor C4 is connected to the other end of the tenth switch S10 and one end of the fourth switch S4, and the other end of the fourth switch S4 is grounded.

As shown in FIG. 6, when the first switch S1 to the fourth switch S4, the fifth switch S5, the seventh switch S7, and the ninth switch S9 are in an off state and the sixth switch S6, the eighth switch S8, and the tenth switch S10 are in an on state, the capacitors C1-C4 are connected in series.

When the first switch S1 to the fourth switch S4, the fifth switch S5, the seventh switch S7, and the ninth switch S9 are in an on state and the sixth switch S6, the eighth switch S8, and the tenth switch S10 are in an off state, the capacitors C1-C4 are connected in parallel.

FIG. 7 is a schematic circuit diagram of a gain amplifier in a case where the passive gain network 101 includes two capacitor sampling arrays and n is equal to 4. As shown in FIG. 7, in a case where the passive gain network 101 includes two capacitor sampling arrays and n is equal to 4, each capacitor sampling array includes: four capacitors and eleven switches. The four capacitors in a first capacitor sampling array are a capacitor C1-1, a capacitor C1-2, a capacitor C1-3, and a capacitor C1-4 respectively, and the eleven switches in the first capacitor sampling array are a switch S1-1, a switch S1-2, a switch S1-3 ... and a switch S1-11 respectively; and the four capacitors in a second capacitor sampling array are a capacitor C2-1, a capacitor C2-2, a capacitor C2-3, and a capacitor C2-4 respectively, and the eleven switches in the second capacitor sampling array are a switch S2-1, a switch S2-2, a switch S2-3 ... and a switch S2-11 respectively.

In some exemplary embodiments, in a case where the passive gain network 101 includes the two capacitor sampling arrays and n is equal to 4, a connection relationship among the four capacitors and the eleven switches in the first capacitor sampling array is as follows:
as shown in FIG. 7, one end of the first switch S1-1 is connected to the input end of the passive gain network and one end of the fifth switch S1-5, the other end of the first switch S1-1 is connected to a top plate of the first capacitor C1-1 and one end of the sixth switch S1-6, and a bottom plate of the first capacitor C1-1 is grounded.

A top plate of the second capacitor C1-2 is connected to the other end of the fifth switch S1-5, one end of the seventh switch S1-7, and one end of the eighth switch S1-8, a bottom plate of the second capacitor C1-2 is connected to the other end of the sixth switch S1-6 and one end of the second switch S1-2, and the other end of the second switch S1-2 is grounded.

A top plate of the third capacitor C1-3 is connected to the other end of the seventh switch S1-7, one end of the ninth switch S1-9, and one end of the tenth switch S1-10, a bottom plate of the third capacitor C1-3 is connected to the other end of the eighth switch S1-8 and one end of the third switch S1-3, and the other end of the third switch S1-3 is grounded.

A top plate of the fourth capacitor C1-4 is connected to the other end of the ninth switch S1-9 and one end of the eleventh switch S1-11, a bottom plate of the fourth capacitor C1-4 is connected to the other end of the tenth switch S1-10 and one end of the fourth switch S1-4, and the other end of the fourth switch S1-4 is grounded.

The other end of the eleventh switch S1-11 is connected to the output end of the passive gain network.

As shown in FIG. 7, when the first switch S1-1 to the fourth switch S1-4, the fifth switch S1-5, the seventh switch S1-7, and the ninth switch S1-9 in the first capacitor sampling array are in an off state, and the sixth switch S1-6, the eighth switch S1-8, and the tenth switch S1-10 in the first capacitor sampling array are in an on state, the capacitors C1-1-C1-4 are connected in series.

When the first switch S1-1 to the fourth switch S1-4, the fifth switch S1-5, the seventh switch S1-7, and the ninth switch S1-9 in the first capacitor sampling array are in an on state, and the sixth switch S1-6, the eighth switch S1-8, and the tenth switch S1-10 in the first capacitor sampling array are in an off state, the capacitors C1-1-C1-4 are connected in parallel.

In some exemplary embodiments, in a case where the passive gain network 101 includes the two capacitor sampling arrays and n is equal to 4, a connection relationship among the four capacitors and the eleven switches in the second capacitor sampling array is as follows:
as shown in FIG. 7, one end of the first switch S2-1 is connected to the input end of the passive gain network and one end of the fifth switch S2-5, the other end of the first switch S2-1 is connected to a top plate of the first capacitor C2-1 and one end of the sixth switch S2-6, and a bottom plate of the first capacitor C2-1 is grounded.

A top plate of the second capacitor C2-2 is connected to the other end of the fifth switch S2-5, one end of the seventh switch S2-7, and one end of the eighth switch S2-8, a bottom plate of the second capacitor C2-2 is connected to the other end of the sixth switch S2-6 and one end of the second switch S2-2, and the other end of the second switch S2-2 is grounded.

A top plate of the third capacitor C2-3 is connected to the other end of the seventh switch S2-7, one end of the ninth switch S2-9, and one end of the tenth switch S2-10, a bottom plate of the third capacitor C2-3 is connected to the other end of the eighth switch S2-8 and one end of the third switch S2-3, and the other end of the third switch S2-3 is grounded.

A top plate of the fourth capacitor C2-4 is connected to the other end of the ninth switch S2-9 and one end of the eleventh switch S2-11, a bottom plate of the fourth capacitor C2-4 is connected to the other end of the tenth switch S2-10 and one end of the fourth switch S2-4, and the other end of the fourth switch S2-4 is grounded.

The other end of the eleventh switch S2-11 is connected to the output end of the passive gain network.

As shown in FIG. 7, when the first switch S2-1 to the fourth switch S2-4, the fifth switch S2-5, the seventh switch S2-7, and the ninth switch S2-9 in the second capacitor sampling array are in an off state, and the sixth switch S2-6, the eighth switch S2-8, and the tenth switch S2-10 in the second capacitor sampling array are in an on state, the capacitors C2-1-C2-4 are connected in series.

When the first switch S2-1 to the fourth switch S2-4, the fifth switch S2-5, the seventh switch S2-7, and the ninth switch S2-9 in the second capacitor sampling array are in an on state, and the sixth switch S2-6, the eighth switch S2-8, and the tenth switch S2-10 in the second capacitor sampling array are in an off state, the capacitors C2-1-C2-4 are connected in parallel.

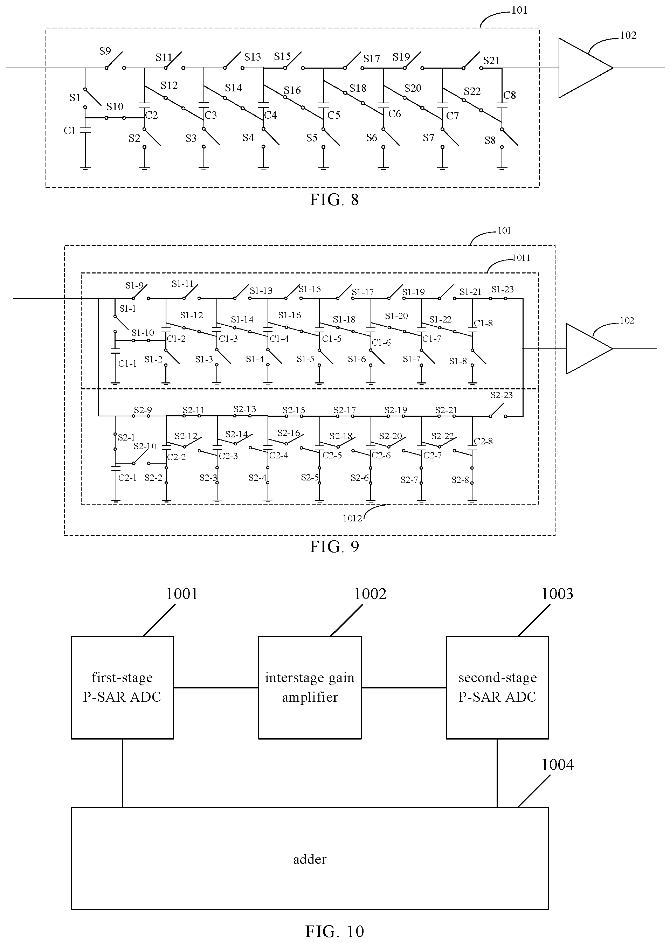

FIG. 8 is a schematic circuit diagram of a gain amplifier in a case where the passive gain network includes one capacitor sampling array and n is equal to 8 according to an embodiment of the present disclosure. FIG. 9 is a schematic circuit diagram of a gain amplifier in a case where the passive gain network includes two capacitor sampling arrays and n is equal to 8 according to an embodiment of the present disclosure. Reference may be made to the above description, FIG. 8, and FIG. 9 for connection modes of the capacitors and the switches and series connection modes and parallel connection modes of the capacitors, and those connection modes will not be repeated here.

As for the gain amplifier provided in the embodiments of the present disclosure, since a gain is merely related to the number of the capacitors and is independent of the environment, the gain is stabilized with no additional calibration circuit or additional compensation circuit, and design complexity and cost are reduced.

FIG. 10 is a block diagram of a P-SAR ADC according to another embodiment of the present disclosure.

In a second aspect, referring to FIG. 10, another embodiment of the present disclosure provides a P-SAR ADC, including: a first-stage P-SAR ADC 1001, an interstage gain amplifier 1002, a second-stage P-SAR ADC 1003, and an adder 1004.

The first-stage P-SAR ADC 1001 is configured to quantize an input voltage signal to obtain a first residual voltage signal and a first quantized voltage signal.

The interstage gain amplifier 1002 is configured to amplify the first residual voltage signal to obtain an amplified first residual voltage signal.

The second-stage P-SAR ADC 1003 is configured to quantize the amplified first residual voltage signal to obtain a second quantized voltage signal.

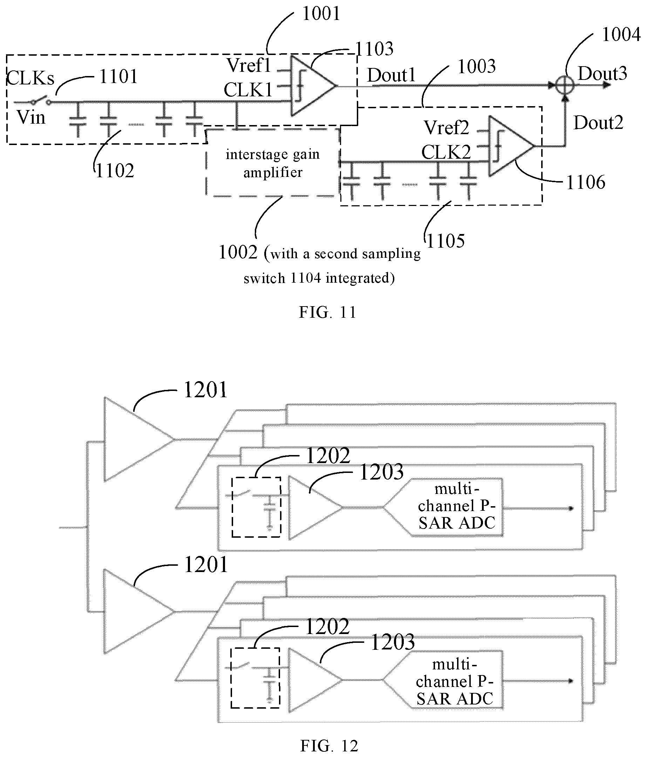

The adder 1004 is configured to add the first quantized voltage signal to the second quantized voltage signal to obtain a final output signal Dout3 (see FIG. 11).

The interstage gain amplifier 1002 includes: a passive gain network 101 and a buffer 102.

The passive gain network 101 includes at least one capacitor sampling array; and each capacitor sampling array includes: n capacitors and (3n-2) switches, with n being an integer greater than or equal to 1.

The passive gain network 101 is configured to sample the first residual voltage signal to obtain a first sampled voltage signal in a case where the n capacitors are connected in parallel under the control of the (3n-2) switches, and amplify the first sampled voltage signal to obtain the amplified first residual voltage signal in a case where the n capacitors are connected in series under the control of the (3n-2) switches.

The buffer 102 is configured to store and output the amplified first residual voltage signal.

In some exemplary embodiments, as shown in FIG. 11, the first-stage P-SAR ADC 1001 includes: a first sampling switch 1101, which is configured to sample the input voltage signal Vin to obtain a second sampled voltage signal; a first digital-to-analog converter 1102, which is configured to quantize the second sampled voltage signal to obtain the first residual voltage signal; and a first comparator 1103, which is configured to compare the first residual voltage signal with a first reference voltage signal Vref1 to obtain the first quantized voltage signal Dout1.

In some exemplary embodiments, the first digital-to-analog converter 1102 may be a capacitive digital-to-analog converter.

In some exemplary embodiments, the first digital-to-analog converter 1102 is further configured to change a voltage at a top plate of a capacitor of the capacitive digital-to-analog converter by controlling a voltage at a bottom plate of the capacitor of the capacitive digital-to-analog converter based on the first quantized voltage signal, thereby changing the first residual voltage signal.

An operating principle of the first-stage P-SAR ADC 1001 is as follows: when the first sampling switch 1101 is closed, the input voltage signal Vin is sampled onto the top plate of the capacitor of the first digital-to-analog converter 1102; and when the first sampling switch 1101 is open, the first comparator 1103 is driven by a clock CLK1 to start to operate, and feeds back a comparison result to the bottom plate of the capacitor of the first digital-to-analog converter 1102 until the first-stage quantization is completed to obtain the first quantized voltage signal Dout1.

Driven by a clock CLKs, the first sampling switch 1101 is switched to be open or closed.

In some exemplary embodiments, as shown in FIG. 11, the second-stage P-SAR ADC 1003 includes: a second sampling switch 1104, which is configured to sample the amplified first residual voltage signal to obtain a third sampled voltage signal; a second digital-to-analog converter 1105, which is configured to quantize the third sampled voltage signal to obtain a second residual voltage signal; and a second comparator 1106, which is configured to compare the second residual voltage signal with a second reference voltage signal Vref2 to obtain the second quantized voltage signal Dout2.

In some exemplary embodiments, the second digital-to-analog converter 1105 may be a capacitive digital-to-analog converter.

In some exemplary embodiments, the second digital-to-analog converter 1105 is further configured to change a voltage at a top plate of a capacitor of the capacitive digital-to-analog converter by controlling a voltage at a bottom plate of the capacitor of the capacitive digital-to-analog converter based on the second quantized voltage signal, thereby changing the second residual voltage signal.

In some exemplary embodiments, as shown in FIG. 11, the second sampling switch 1104 may be integrated in the interstage gain amplifier 1002. That is, the interstage gain amplifier 1002 includes the passive gain network 101, the buffer 102, and the second sampling switch 1104, and the second-stage P-SAR ADC 1003 includes: the second digital-to-analog converter 1105 and the second comparator 1106.

An operating principle of the second-stage P-SAR ADC 1003 is as follows: when the second sampling switch 1104 is closed, the first residual voltage signal is sampled onto the top plate of the capacitor of the second digital-to-analog converter 1105; and when the second sampling switch 1104 is open, the second comparator 1106 is driven by a clock CLK2 to start to operate, and feeds back a comparison result to the bottom plate of the capacitor of the second digital-to-analog converter 1105 until the second-stage quantization is completed to obtain the second quantized voltage signal Dout2.

In some exemplary embodiments, the passive gain network 101 may include one capacitor sampling array or two capacitor sampling arrays. In a case where the passive gain network 101 includes two capacitor sampling arrays, as shown in FIG. 3, the two capacitor sampling arrays included in the passive gain network 101 are the first capacitor sampling array 1011 and the second capacitor sampling array 1012, respectively.

In some exemplary embodiments, the passive gain network 101 includes: a first capacitor sampling array and a second capacitor sampling array.

The first capacitor sampling array is configured to, in a (2j-1)^{th} period, sample the first residual voltage signal to obtain the first sampled voltage signal in a case where the n capacitors are connected in parallel under the control of the (3n-2) switches, and amplify the first sampled voltage signal to obtain the amplified first residual voltage signal in a case where the n capacitors are connected in series under the control of the (3n-2) switches; and hold the amplified first residual voltage signal in a 2j^{th} period, with j being an integer greater than or equal to 1.

The second capacitor sampling array is configured to, in the 2j^{th} period, sample the first residual voltage signal to obtain the first sampled voltage signal in a case where the n capacitors are connected in parallel under the control of the (3n-2) switches, and amplify the first sampled voltage signal to obtain the amplified first residual voltage signal in a case where the n capacitors are connected in series under the control of the (3n-2) switches; and hold the amplified first residual voltage signal in a (2j+1)^{th} period.

The buffer is configured to store and output the amplified first residual voltage signal from the first capacitor sampling array in the (2j-1)^{th} period, and store and output the amplified first residual voltage signal from the second capacitor sampling array in the 2j^{th} period.

In some exemplary embodiments, the period herein refers to a sampling period of the capacitor sampling arrays.

The implementation of the passive gain network 1011 is the same as the above embodiments and will not be repeated here.

As for the P-SAR ADC provided in the embodiments of the present disclosure, since a gain of the interstage gain amplifier is merely related to the number of the capacitors and is independent of the environment, the gain of the interstage gain amplifier is stabilized with no additional calibration circuit or additional compensation circuit, and design complexity and cost are reduced.

FIG. 12 is a block diagram of a time-interleaved P-SAR ADC according to another embodiment of the present disclosure.

In a third aspect, referring to FIG. 12, another embodiment of the present disclosure provides a time-interleaved P-SAR ADC, including: a first-stage input buffer 1201, which is configured to receive an input signal and drive a subsequent circuit; a sample holding network 1202, which is configured to perform sample holding on an output signal from the first-stage input buffer 1201, and transfer the output signal to a second-stage buffer 1203; and the second-stage buffer 1203, which is configured to receive the signal sampled by the sample holding network 1202, and output the signal to a multi-channel ADC.

In some exemplary embodiments, the multi-channel ADC includes at least two P-SAR ADCs that are connected in parallel and described in the above embodiments.

In some exemplary embodiments, the sample holding network operates at a sampling rate of 1/A, with A denoting the number of channels included in the multi-channel ADC, i.e., the number of the P-SAR ADCs.

For example, for a 64-channel time-interleaved P-SAR ADC, an output end of the first-stage buffer 1201 may be connected in parallel to eight branches each including the sample holding network 1202, the second-stage buffer 1203, and the multi-channel ADC, and an output end of each second-stage buffer 1203 is connected to an 8-channel ADC.

As for the time-interleaved P-SAR ADC provided in the embodiments of the present disclosure, since a gain of the interstage gain amplifier is merely related to the number of the capacitors and is independent of the environment, stabilization of the gain of the interstage gain amplifier and a gain match between the channels are realized with no additional calibration circuit or additional compensation circuit, and design complexity and cost are reduced.

The present disclosure discloses the exemplary embodiments using specific terms, but the terms are merely used and should be merely interpreted as having general illustrative meanings, rather than for the purpose of limitation. Unless expressly stated, it is apparent to those of ordinary skill in the art that the features, characteristics and/or elements described in connection with a particular embodiment can be used alone or in combination with the features, characteristics and/or elements described in connection with other embodiments. Therefore, it should be understood by those of ordinary skill in the art that various changes in forms and details can be made without departing from the scope of the present disclosure of the appended claims.

## Claims

1. A gain amplifier, comprising:
a passive gain network and a buffer;
wherein the passive gain network comprises at least one capacitor sampling array; each of the at least one capacitor sampling array comprises: n capacitors and (3n-2) switches; wherein n is an integer greater than or equal to 1;
wherein the passive gain network is configured to sample an input signal to obtain a sampled signal in a case where the n capacitors are connected in parallel under the control of the (3n-2) switches, and amplify the sampled signal to obtain an amplified signal in a case where the n capacitors are connected in series under the control of the (3n-2) switches;
wherein the buffer is configured to store and output the amplified signal.

2. The gain amplifier of claim 1, wherein the passive gain network comprises: a first capacitor sampling array and a second capacitor sampling array;
wherein the first capacitor sampling array is configured to, in a (2j-1)^{th} period, sample the input signal to obtain the sampled signal in a case where the n capacitors are connected in parallel under the control of the (3n-2) switches, and amplify the sampled signal to obtain the amplified signal in a case where the n capacitors are connected in series under the control of the (3n-2) switches; and hold the amplified signal in a 2j^{th} period; wherein j is an integer greater than or equal to 1;
the second capacitor sampling array is configured to, in the 2j^{th} period, sample the input signal to obtain the sampled signal in a case where the n capacitors are connected in parallel under the control of the (3n-2) switches, and amplify the sampled signal to obtain the amplified signal in a case where the n capacitors are connected in series under the control of the (3n-2) switches; and hold the amplified signal in a (2j+1)^{th} period; and
the buffer is configured to store and output the amplified signal from the first capacitor sampling array in the (2j-1)^{th} period, and store and output the amplified signal from the second capacitor sampling array in the 2j^{th} period.

3. The gain amplifier of claim 1, wherein one end of a first switch is connected to an input end of the passive gain network and one end of a (n+1)^{th} switch, the other end of the first switch is connected to a top plate of a first capacitor and one end of a (n+2)^{th} switch, and a bottom plate of the first capacitor is grounded;
in a case where i is greater than or equal to 2 and less than n, a top plate of an i^{th} capacitor is connected to the other end of a (n+2i-3)^{th} switch, one end of a (n+2i-1)^{th} switch, and one end of a (n+2i)^{th} switch, a bottom plate of the i^{th} capacitor is connected to the other end of a (n+2i-2)^{th} switch and one end of an i^{th} switch, and the other end of the i^{th} switch is grounded; and
a top plate of an n^{th} capacitor is connected to the other end of a (3n-3)^{th} switch and an output end of the passive gain network, a bottom plate of the n^{th} capacitor is connected to the other end of a (3n-2)^{th} switch and one end of an n^{th} switch, and the other end of the n^{th} switch is grounded.

4. The gain amplifier of claim 3, wherein in a case where the passive gain network comprises: a first capacitor sampling array and a second capacitor sampling array, the first capacitor sampling array and/or the second capacitor sampling array further comprises: a (3n-1)^{th} switch; and
the top plate of the n^{th} capacitor is connected to one end of the (3n-1)^{th} switch, and the other end of the (3n-1)^{th} switch is connected to the output end of the passive gain network.

5. The gain amplifier of any one of claims 1 to 4, wherein n is equal to 2^{m}, and m is an integer greater than or equal to 1.

6. A pipelined successive approximation register analog-to-digital converter, comprising:
a first-stage pipelined successive approximation register analog-to-digital converter, which is configured to quantize an input voltage signal to obtain a first residual voltage signal and a first quantized voltage signal;
an interstage gain amplifier, which is configured to amplify the first residual voltage signal to obtain an amplified first residual voltage signal;
a second-stage pipelined successive approximation register analog-to-digital converter, which is configured to quantize the amplified first residual voltage signal to obtain a second quantized voltage signal; and
an adder, which is configured to add the first quantized voltage signal to the second quantized voltage signal to obtain a final output signal;
wherein the interstage gain amplifier comprises: a passive gain network and a buffer;
wherein the passive gain network comprises at least one capacitor sampling array; each of the at least one capacitor sampling array comprises: n capacitors and (3n-2) switches; wherein n is an integer greater than or equal to 1;
wherein the passive gain network is configured to sample the first residual voltage signal to obtain a first sampled voltage signal in a case where the n capacitors are connected in parallel under the control of the (3n-2) switches, and amplify the first sampled voltage signal to obtain the amplified first residual voltage signal in a case where the n capacitors are connected in series under the control of the (3n-2) switches;
wherein the buffer is configured to store and output the amplified first residual voltage signal.

7. The pipelined successive approximation register analog-to-digital converter of claim 6, wherein the first-stage pipelined successive approximation register analog-to-digital converter comprises:
a first sampling switch, which is configured to sample the input voltage signal to obtain a second sampled voltage signal;
a first digital-to-analog converter, which is configured to quantize the second sampled voltage signal to obtain the first residual voltage signal; and
a first comparator, which is configured to compare the first residual voltage signal with a first reference voltage signal to obtain the first quantized voltage signal.

8. The pipelined successive approximation register analog-to-digital converter of claim 6, wherein the second-stage pipelined successive approximation register analog-to-digital converter comprises:
a second sampling switch, which is configured to sample the amplified first residual voltage signal to obtain a third sampled voltage signal;
a second digital-to-analog converter, which is configured to quantize the third sampled voltage signal to obtain a second residual voltage signal; and
a second comparator, which is configured to compare the second residual voltage signal with a second reference voltage signal to obtain the second quantized voltage signal.

9. The pipelined successive approximation register analog-to-digital converter of claim 6, wherein the passive gain network comprises: a first capacitor sampling array and a second capacitor sampling array;
wherein the first capacitor sampling array is configured to, in a (2j-1)^{th} period, sample the first residual voltage signal to obtain the first sampled voltage signal in a case where the n capacitors are connected in parallel under the control of the (3n-2) switches, and amplify the first sampled voltage signal to obtain the amplified first residual voltage signal in a case where the n capacitors are connected in series under the control of the (3n-2) switches; and hold the amplified first residual voltage signal in a 2j^{th} period; wherein j is an integer greater than or equal to 1;
the second capacitor sampling array is configured to, in the 2j^{th} period, sample the first residual voltage signal to obtain the first sampled voltage signal in a case where the n capacitors are connected in parallel under the control of the (3n-2) switches, and amplify the first sampled voltage signal to obtain the amplified first residual voltage signal in a case where the n capacitors are connected in series under the control of the (3n-2) switches; and hold the amplified first residual voltage signal in a (2j+1)^{th} period; and
the buffer is configured to store and output the amplified first residual voltage signal from the first capacitor sampling array in the (2j-1)^{th} period, and store and output the amplified first residual voltage signal from the second capacitor sampling array in the 2j^{th} period.
